# FASCICULE DE BREVET EUROPEEN

(11) **EP 4 702 330 B1**
(45) Date de publication et mention de la délivrance du brevet: **11.11.2026**
(21) Numéro de dépôt: 24721968.6
(22) Date de dépôt: 24.04.2024
(51) Int. Cl.: G01J 5/20, H10F 30/21, H10F 39/00, H10F 77/14, G01J 5/08, H10F 39/18

(54) **ARCHITECTURE D'UNE ZONE D'ABSORPTION POUR UN DETECTEUR INFRAROUGE**
AUFBAU EINER ABSORPTIONSZONE FÜR EINEN INFRAROTDETEKTOR
ARCHITECTURE OF AN ABSORPTION ZONE FOR AN INFRARED DETECTOR

(30) Priorité: 27.04.2023 FR 2304271
(43) Date de publication de la demande: 04.03.2026
(73) Titulaire: Commissariat à l'Energie Atomique et aux Energies Alternatives, 75015 Paris (FR); LYNRED, 38113 Veurey-Voroize (FR)
(72) Inventeur: EVIRGEN, Axel, 91767 PALAISEAU (FR); GERARD, Bruno, 91767 PALAISEAU (FR)
(74) Mandataire: Atout PI Laplace
(86) Numéro de dépôt international: PCT/EP2024/061202
(87) Numéro de publication internationale: WO 2024/223628

(56) Documents cités:
- US-A1- 2012 145 996
- EASLEY JUSTIN ET AL: "InGaAs/GaAsSb Type-II Superlattices for Short-Wavelength Infrared Detection", JOURNAL OF ELECTRONIC MATERIALS, SPRINGER US, NEW YORK, vol. 48, no. 10, 22 July 2019 (2019-07-22), pages 6025 - 6029, XP036879455, ISSN: 0361-5235, [retrieved on 20190722], DOI: 10.1007/S11664-019-07441-X

## Description

### Domaine de l'invention

La présente invention concerne le domaine de l'imagerie pour l'infra-rouge (IR) et en particulier un détecteur de rayonnement ou photo détecteur fabriqué avec des hétérostructures à base de matériaux semi-conducteurs de type III-V. Plus particulièrement, l'invention concerne un dispositif d'imagerie dans le lointain infrarouge (LWIR), le moyen infrarouge (MWIR) et le proche infrarouge (SWIR).

### Problème soulevé

Les imageurs opérant dans la gamme infrarouge sont généralement constitués par assemblage d'une matrice comprenant une pluralité de pixels élémentaires à base de photodiodes transformant un flux de photons incidents en porteurs de charges photo générés, et d'un circuit de lecture couramment dénommé ROIC pour « Read Out Integrated Circuit » en anglais pour traiter le signal électrique issu des pixels du détecteur.

L'invention se propose de résoudre un problème technique dans ce domaine consistant à concevoir un détecteur matriciel fonctionnant dans l'infrarouge à des températures cryogéniques pour le MWIR et le LWIR et non cryogénique pour le SWIR en réduisant le phénomène de diaphonie (traduction du terme cross-talk en Anglais) entre les pixels de la matrice à un pas inférieur à 15µm, sans augmenter le bruit de courant noir par rapport aux solutions de l'état de l'art.

Nous allons commencer par expliquer physiquement ces deux caractéristiques interdépendantes d'un capteur matriciel infrarouge.

A titre d'illustration, dans un espace (X,Y,Z) on définit l'axe Δ de chaque pixel selon la direction Z, et le plan ayant pour normale l'axe du pixel, dit plan normal, est le plan (X, Y).

Chaque détecteur matriciel infrarouge est caractérisé par une longueur d'onde de coupure λc définie par le gap d'énergie effective Eg_{eff} de la zone absorbante de chaque pixel du détecteur matriciel selon la relation Planck-Einstein λc=hc/Eg_{eff} avec h la constante de Planck et c la célérité de la lumière dans le vide. La longueur de coupure dépend alors de la structure de bandes d'énergie des matériaux utilisés pour la réalisation de la zone absorbante du pixel.

Le phénomène de diaphonie (cross-talk) provient de l'interférence entre des pixels adjacents, les charges photo générées par un pixel pouvant diffuser vers un pixel voisin selon le plan ayant pour normale l'axe du pixel. L'amplitude du phénomène de diaphonie dans un détecteur matriciel infrarouge augmente avec la longueur de diffusion des porteurs de charges minoritaires dans le plan normal (X,Y) notée L_{dx,y.} La longueur de diffusion L_{dx,y} selon le plan normal au pixel augmente avec le coefficient de diffusion dans le même plan. Le coefficient de diffusion est inversement proportionnel aux masses effectives mₕₓ et m_{hy} des porteurs de charges minoritaires (trous dans le cas d'une zone absorbante dopée N) dans le plan normal au pixel. Le phénomène de diaphonie constitue une limitation technique pour le bon fonctionnement des matrices de pixel à pas réduit, notamment inférieur à 15µm.

Par exemple, pour un détecteur dans le moyen infrarouge, la longueur de diffusion est généralement supérieure à 15µm. Ainsi, pour un pas de pixel inférieur à 15µm, la résolution de l'imageur est dégradée par rapport à la résolution théorique qu'elle peut atteindre. Pour quantifier cette dégradation, la fonction de transfert de modulation (FTM) est mesurée à la fréquence de Nyquist. La valeur obtenue pour les solutions de l'état de l'art est inférieure à 0,5 par rapport à une valeur théorique de 0,64.

Le courant d'obscurité Jₙₒᵢᵣ est le courant de porteurs de charges générés en l'absence de rayonnements incidents dans les matériaux qui composent la zone absorbante d'un pixel de la matrice de détection. On peut exprimer le courant noir par la formule suivante : ${J}_{noir} = \frac{{{n}_{i}}^{2}}{τN} d$ Avec nᵢ la densité de porteurs de charge intrinsèque dans la zone d'absorption, τ la durée de vie des porteurs de charge minoritaires, N est le dopage et d est l'épaisseur de la zone absorbante. N et d sont des paramètres dimensionnels, τ dépend des conditions de fabrication.

Pour résumer, l'enjeu technique est de trouver une solution permettant de limiter la dégradation de la résolution avec la réduction du pas pixel à cause de l'augmentation de la diaphonie sans augmenter le courant d'obscurité et cela pour une fréquence de coupure donnée à une température de fonctionnement donnée.

Le problème technique à résoudre est alors de développer des détecteurs infrarouges avec des pixels comprenant des zones absorbantes avec une amélioration des critères interdépendants suivants : maximisation de la fonction de transfert de modulation (FTM) d'un système de détection et minimisation simultanée des contraintes de diaphonie et de bruit de courant noir à une fréquence de coupure donnée, à un pas de pixel donné et à une température de fonctionnement donnée.

### Art antérieur/ Restrictions de l'état de l'art

La publication « Large format InSb infrared detector with 10µm pixels" de Gershon et al présente un détecteur infrarouge avec une matrice de pixel à un pas de pixel de 15µm et de 10µm à 150K. La solution décrite présente une fonction de transfert de modulation inférieure à 0,45 pour un pas de 15µm et inférieure à 0,35 pour un pas de 10µm. Cela reflète une dégradation de la performance du détecteur à cause de l'augmentation des effets de diaphonie entre les pixels adjacents. US 2012/145996 A1 et EASLEY JUSTIN ET AL: "InGaAs/GaAsSb Type-II Superlattices for Short-Wavelength Infrared Detection", JOURNAL OF ELECTRONIC MATERIALS, SPRINGER US, NEW YORK, vol. 48, no. 10, 22 juillet 2019, pages 6025-6029 divulguent de l'art antérieur.

### Réponse au problème et apport solution

Pour pallier les limitations des solutions existantes en ce qui concerne l'amélioration de la résolution tout en minimisant la diaphonie et le courant d'obscurité, l'invention propose plusieurs modes de réalisation d'une structure de pixels comprenant une hétérostructure d'absorption présentant au moins deux structures planaires adjacentes ayant des gaps d'énergie proches et des niveaux de bandes de valence et/ou de conduction décalés. Ce décalage de bandes d'énergie permet de créer un champ électrique local au niveau de l'interface entre les deux structures planaires adjacentes. Le champ électrique local est orienté selon l'axe du pixel, l'axe Δ, de manière à canaliser les porteurs de charge selon la direction axiale du pixel. Cela permet de réduire le transport des porteurs de charge selon le plan (X,Y) et ainsi limiter le phénomène de diaphonie. Le décalage entre les niveaux de bandes de valence (et/ou de conduction) est inférieur à 4kT avec k la constante de Boltzmann et T la température de fonctionnement prédéterminée. Cela permet de garder une structure en bande d'énergie plate dans l'hétérostructure planaire et ainsi éviter l'augmentation du courant d'obscurité par l'apparition d'une zone de charge d'espace désertée de porteurs de charge.

Avantageusement, l'hétérostructure d'absorption comprend une alternance répétitive des structures planaires adjacentes selon l'invention pour améliorer la canalisation des porteurs de charges selon l'axe du pixel.

Avantageusement, l'hétérostructure d'absorption comprend une succession de plusieurs structures d'absorption avec des matériaux différents selon l'invention de manière à former un diagramme d'énergie en escalier descendant selon la direction axiale du pixel.

Les structures planaires d'absorption adjacentes selon l'invention peuvent être réalisées par un super-réseau ou en un matériau massif. L'invention détaille des modes de réalisation avec des exemples de choix de matériaux pour les structures planaires d'absorption, des plages de compositions des alliages semiconducteurs et des plages de dimensionnement des épaisseurs des couches de l'hétérostructure d'absorption selon l'invention. Les compositions (fractions molaires des alliages III-V) des matériaux utilisés pour réaliser les couches de l'hétérostructure d'absorption selon l'invention sont choisies de manière à obtenir le diagramme de bandes d'énergie selon l'invention. Cela permet d'améliorer en même temps, par rapport aux solutions de l'état de l'art, les performances du détecteur IR en termes de rendement quantique, de réduction du courant d'obscurité et de réduction de la diaphonie (cross-talk).

### Résumé /Revendications

L'invention a pour objet un dispositif de détection configuré pour détecter des rayonnements infrarouges à une température de fonctionnement prédéterminée, comprenant au moins un pixel réalisé par un empilement de couches sur un substrat selon la première direction normale audit substrat , ledit pixel comprenant une hétérostructure d'absorption; ladite hétérostructure d'absorption comprenant au moins:
- une première structure planaire d'absorption ayant une première valeur de maximum de bande de valence ;
- et une deuxième structure planaire d'absorption adjacente à la première structure planaire d'absorption ;
ladite deuxième structure planaire d'absorption ayant une deuxième valeur de maximum de bande de valence distincte de la première valeur de maximum de bande de valence ; l'épaisseur de chacune de la première et de la deuxième structure planaire d'absorption étant choisie de manière à créer au moins un champ électrique d'interface au niveau de l'interface entre la deuxième structure planaire d'absorption et la première structure planaire d'absorption ; ledit champ électrique d'interface étant orienté selon ladite première direction.

Selon un aspect particulier de l'invention, la différence entre la première valeur de maximum de bande de valence et la deuxième valeur de maximum de bande de valence est inférieure à quatre fois le produit de la constante de Boltzmann par la température de fonctionnement.

Selon l'invention, l'épaisseur de chacune de la première et de la deuxième structure planaire d'absorption est supérieure ou égale à 20 nm.

Selon un aspect particulier de l'invention, la première structure planaire d'absorption présente un premier gap d'énergie et la deuxième structure planaire d'absorption présente un deuxième gap d'énergie ; l'écart absolu entre le premier gap d'énergie et le deuxième gap d'énergie est inférieur ou égal à 20 meV .

Selon un aspect particulier de l'invention, la première structure planaire d'absorption présente une première valeur de minimum de bande de conduction et la deuxième structure planaire d'absorption présente une deuxième valeur de minimum de bande de conduction distincte de la première valeur de minimum de bande de conduction avec un écart d'énergie inférieur à quatre fois le produit de la constante de Boltzmann par la température de fonctionnement.

Selon un aspect particulier de l'invention, l'hétérostructure d'absorption comprend une alternance périodique de la première structure planaire d'absorption et de la deuxième structure planaire d'absorption.

Selon un aspect particulier de l'invention, l'hétérostructure d'absorption est dopée par des dopants de type N ou P, la concentration desdits dopants étant asymétrique de part et d'autre d'au moins une interface entre une première structure planaire d'absorption et une deuxième structure planaire d'absorption .

Selon un aspect particulier de l'invention, l'hétérostructure d'absorption est dopée par des dopants de type N ou P, la concentration desdits dopants présentant un gradient décroissant en partant de l'interface avec l'électrode inférieure vers l'interface avec l'électrode supérieure.

Selon un aspect particulier de l'invention, la zone d'absorption comprend un empilement d'une succession de plusieurs structures planaires d'absorption de rang i=1 à N croissant en partant du substrat selon la première direction, avec N un entier naturel strictement supérieur à 1, tel que :
- chaque structure planaire d'absorption de rang i=1 à N-1 présente une valeur de maximum de bande de valence strictement supérieure à la valeur de maximum de bande de valence de la structure planaire d'absorption de rang i+1, de manière à créer au moins un champ électrique d'interface dirigé selon la première direction au niveau de chaque interface ;
ladite succession de plusieurs structures planaires d'absorption comprenant l'ensemble formé par la première structure planaire d'absorption et la deuxième structure planaire d'absorption.

Selon un aspect particulier de l'invention, la différence entre d'une part la valeur de maximum de bande de valence d'une structure planaire d'absorption de rang i=1 à N-1 et d'autre part la valeur de maximum de bande de valence d'une structure planaire d'absorption adjacente de rang i+1 est inférieure à quatre fois le produit de la constante de Boltzmann par la température de fonctionnement .

Selon un aspect particulier de l'invention, l'écart absolu entre les gaps d'énergies associés à deux structures planaires d'absorption adjacentes est inférieur ou égal à 20 meV.

Selon un aspect particulier de l'invention, chaque structure planaire d'absorption est réalisée par des matériaux semiconducteurs de type III-V.

Selon un aspect particulier de l'invention, le substrat est en GaSb ou en InAs ou en InP ou en GaAs.

Selon un aspect particulier de l'invention, la première structure planaire d'absorption est réalisée par une première couche massive en un premier matériau ou un premier super-réseau et la deuxième structure planaire d'absorption est réalisée par une deuxième couche massive en un deuxième matériau différent dudit premier matériau ou un deuxième super-réseau.

Selon un aspect particulier de l'invention, le premier matériau est l'alliage InAs_{1-y}Sb_{y} ou l'alliage Ga₁₋ₓInₓAs ou l'alliage GaₓIn₁₋ₓAs_{1-y}Sb_{y} ou l'alliage GaₓIn₁₋ₓAs_{1-y}P_{y}.

Selon un aspect particulier de l'invention, le deuxième matériau est l'alliage GaₓIn₁₋ₓAs_{1-y}Sb_{y} ou l'alliage Ga₁₋ₓInₓAs ou l'alliage GaₓIn₁₋ₓAs_{1-y}P_{y}.

Selon un aspect particulier de l'invention, le premier super-réseau et/ou le deuxième super-réseau est constitué par une alternance selon une période spatiale prédéterminée d'un couple de couches en InAs_{1-y}Sb_{y}/GaₓIn₁₋ₓAs_{1-y}Sb_{y} ou en InₓGa₁₋ₓAs/InₓGa₁₋ₓAs_{1-y}P_{y} ou en Inₓ₁Ga₁₋ₓ₁As_{1-y1}Sb_{y1} /Inₓ₂Ga₁₋ₓ₂As_{1-y2}Sb_{y2}.

Selon un aspect particulier de l'invention, le dispositif de détection comprend en outre une matrice de pixels ayant un pas de pixel inférieur ou égal à 15µm.

### Description détaillée

Dans le cadre de la description de l'invention, le terme « structure planaire d'absorption » définit une couche en un matériau massif ou un empilement de couches formant un super-réseau apte à convertir un rayon incident en des porteurs de charge.

D'autres caractéristiques et avantages de la présente invention apparaîtront mieux à la lecture de la description qui suit en relation aux dessins annexés suivants.

La figure 1 illustre une vue en perspective d'un exemple de pixel appartenant à un détecteur matriciel dans le domaine de fréquences infrarouges.

La figure 2a illustre une vue en coupe d'un pixel détecteur infrarouge comprenant une hétérostructure d'absorption selon un premier mode de réalisation de l'invention.

La figure 2b illustre un schéma de la structure des bandes de l'hétérostructure d'absorption selon le premier mode de réalisation de l'invention dans la direction de l'axe du pixel.

La figure 2c illustre la distribution du champ électrique dans l'hétérostructure d'absorption selon le premier mode de réalisation de l'invention dans la direction de l'axe du pixel.

La figure 3a illustre une vue en coupe d'un pixel détecteur infrarouge comprenant une hétérostructure d'absorption selon un deuxième mode de réalisation de l'invention.

La figure 3b illustre la distribution du champ électrique dans l'hétérostructure d'absorption selon le deuxième mode de réalisation de l'invention dans la direction de l'axe du pixel.

La figure 4 illustre une vue en coupe d'un pixel détecteur infrarouge comprenant une hétérostructure d'absorption selon un troisième mode de réalisation de l'invention.

La figure 5a illustre une vue en coupe d'un pixel détecteur infrarouge comprenant une hétérostructure d'absorption selon un quatrième mode de réalisation de l'invention.

La figure 5b illustre un schéma de la structure des bandes de l'hétérostructure d'absorption selon le quatrième mode de réalisation de l'invention dans la direction de l'axe du pixel.

La figure 5c illustre la distribution du champ électrique dans l'hétérostructure d'absorption selon le quatrième mode de réalisation de l'invention dans la direction de l'axe du pixel.

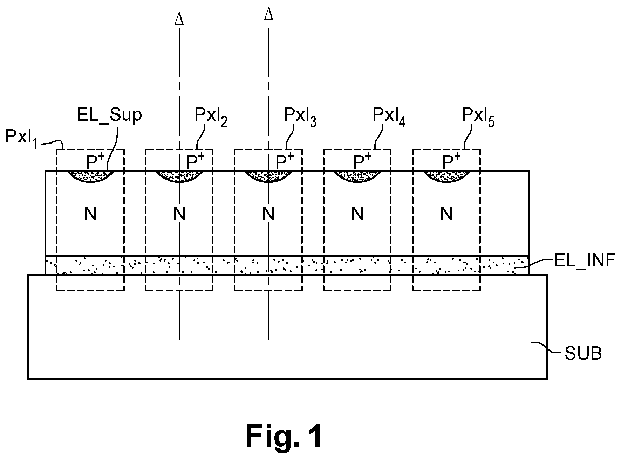

La figure 1 illustre une vue en perspective d'un exemple de plusieurs pixels adjacents appartenant à un détecteur matriciel D1 dans le domaine de fréquences infrarouges.

L'illustration est limitée à une seule rangée de pixels Pxl₁ à Pxl₅ par souci de simplification mais elle n'exclut pas l'intégration des pixels dans une matrice comprenant une pluralité de lignes et de colonnes de pixels.

Un pixel Pxlᵢ (i=1 à 5) du détecteur infrarouge est réalisé par un empilement de couches en matériaux semi-conducteurs formant la structure du pixel sur un substrat SUB. L'axe du pixel Δ est l'axe perpendiculaire au plan horizontal (x,y) formé par la surface supérieure du substrat SUB. Le substrat SUB est réalisé en un matériau massif semi-conducteur de type III-V par exemple. Le choix du matériau du substrat SUB est important car déterminant la technologie des étapes du procédé de fabrication du dispositif mais aussi les caractéristiques techniques (optiques, électriques, mécaniques...) du détecteur matriciel. Le pixel Pxlᵢ comprend les couches (ou multicouches) suivantes, en partant du substrat, selon la direction de l'axe du pixel Δ : une électrode inférieure EL_INF, une zone d'absorption SPA et une électrode supérieure EL_SUP.

L'électrode inférieure EL_INF est confinée entre la zone d'absorption SPA et le substrat SUB. L'électrode inférieure EL_INF peut être réalisée en matériau massif semi-conducteur ou en matériau super-réseau dopé N+. Préférentiellement, le matériau constituant l'électrode inférieure EL_INF est de type III-V tel que, à titre d'exemple, l'arséniure de gallium, arséniure d'indium, nitrure de gallium, antimoniure de gallium, antimoniure d'indium, phosphure d'indium, phosphure de bore, ainsi que leurs alliages ternaires ou quaternaires ou quinaires. L'électrode inférieure EL_INF peut également être réalisée avec des hétérostructures obtenues par un empilement d'une pluralité de couches fines de matériaux semi-conducteurs massif ou super-réseau dopés N, N+, préférentiellement de type III-V tel que, à titre d'exemple, l'arséniure de gallium, arséniure d'indium, nitrure de gallium, antimoniure de gallium, antimoniure d'indium, phosphure d'indium, phosphure de bore, ainsi que leurs alliages ternaires ou quaternaires ou quinaires. Alternativement, l'électrode inférieure EL_INF constitue à titre d'exemple un super-réseau dopé N+ présentant une grande valeur de gap d'énergie par rapport à la zone d'absorption SPA.

La zone d'absorption SPA est réalisée par un empilement de couches dopé N et présente une valeur de gap d'énergie inférieure ou égale à celle de l'électrode supérieure. Les caractéristiques du diagramme de bandes de la zone d'absorption SPA (bande de valence, bande de conduction, énergie de gap) sont intrinsèques dans le cas d'un matériau massif, ou effectives résultant de la combinaison des différentes couches fines dans le cas d'un super-réseau. Dans le cadre de la description de l'invention, la qualification de « effective » a été omise pour les super-réseaux pour simplifier la description.

La zone d'absorption SPA convertit le flux de photons incidents avec une longueur d'onde λ en porteurs de charge négative « électrons » dans la bande de conduction et de charge positive « trous » dans la bande de valence de la zone d'absorption SPA. Pour les dispositifs visés par l'invention, il s'agit d'un effet photoélectrique où les porteurs de charge minoritaires (les trous pour un dopage N) sont utilisés pour générer le signal de lecture suite à la stimulation par un rayonnement infrarouge. Les matériaux semi-conducteurs utilisés pour réaliser la zone d'absorption SPA (sous forme de matériau massif ou super-réseau) peuvent être de type III-V tel que, à titre d'exemple, l'arséniure de gallium, arséniure d'indium, nitrure de gallium, antimoniure de gallium, antimoniure d'indium, phosphure d'indium phosphure de bore, ainsi que leurs alliages ternaires ou quaternaires ou quinaires. La structure des bandes d'énergie dans la zone d'absorption SPA est déterminante pour augmenter la fréquence de coupure du détecteur matriciel comprenant le pixel Pxlᵢ. Dans l'exemple illustré, la zone d'absorption SPA est dopée N.

L'électrode supérieure EL_SUP est réalisée, à titre d'exemple non limitatif, par une zone de dopage P+ au niveau de la face supérieure de la zone d'absorption SPA. Alternativement, il est possible de réaliser l'électrode supérieure EL_SUP en matériaux présentant généralement une grande valeur de gap d'énergie par rapport à la zone d'absorption SPA. Ces matériaux sont préférentiellement de type III-V tel que, à titre d'exemple, l'arséniure de gallium, arséniure d'indium, nitrure de gallium, antimoniure de gallium, antimoniure d'indium, phosphure d'indium, phosphure de bore, ainsi que leurs alliages ternaires ou quaternaires ou quinaires. L'électrode supérieure EL_SUP peut également être réalisée avec des hétérostructures obtenues par un empilement d'une pluralité de couches fines de matériaux semi-conducteurs préférentiellement de type III-V tels que, à titre d'exemple, l'arséniure de gallium, arséniure d'indium, nitrure de gallium, antimoniure de gallium, antimoniure d'indium, phosphure d'indium phosphure de bore, ainsi que leurs alliages ternaires ou quaternaires ou quinaires. L'électrode supérieure EL_SUP constitue à titre d'exemple un super-réseau dopé P+ présentant une grande valeur de gap d'énergie par rapport à la zone d'absorption SPA. L'électrode supérieure EL_SUP est destinée à collecter les charges générées par la zone d'absorption SPA.

Le dopage différent entre l'électrode supérieure EL_SUP et la zone d'absorption induit que le sens de migration des charges positives photo générées est de l'électrode inférieure EL_INF vers l'électrode supérieure EL_SUP.

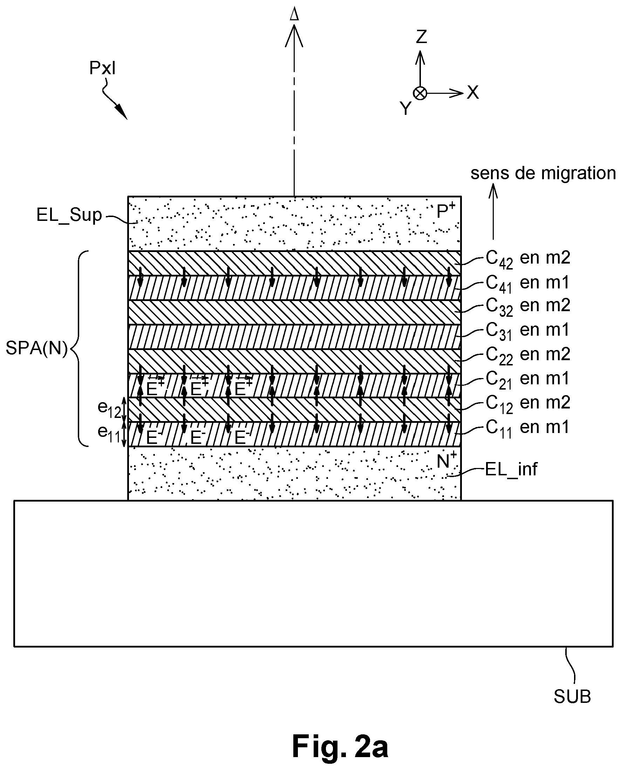

La figure 2a illustre une vue en coupe d'un pixel Pxl détecteur infrarouge comprenant une hétérostructure d'absorption SPA selon un premier mode de réalisation de l'invention.

La zone d'absorption SPA est une hétérostructure obtenue par un empilement selon la direction axiale Z. L'hétérostructure d'absorption SPA comprend N structures planaires d'absorption (C₁₁, C₂₁, C₃₁...) correspondant à des couches massives en un premier matériau m1 avec N un entier naturel non nul. L'hétérostructure d'absorption SPA comprend en outre N structures planaires d'absorption (C₁₂, C₂₂, C₃₂...) correspondant à des couches massives en un deuxième matériau m2 avec N un entier naturel non nul. Les structures planaires sont empilées de manière alternée de manière à obtenir une hétérostructure formée par des couches massives adjacentes en différents matériaux m1 et m2. Le premier matériau m1 est un semiconducteur caractérisé par une première valeur de maximum de bande de valence Ev₁, une première valeur de minimum de bande de conduction Ec₁, et une première valeur de gap d'énergie E_{g1}. Le deuxième matériau m2 est un semi-conducteur caractérisé par une deuxième valeur de maximum de bande de valence Ev₂, une deuxième valeur de minimum de bande de conduction Ec₂ et une deuxième valeur de gap d'énergie Eg₂. La deuxième valeur de maximum de bande de valence Ev₂ est distincte de la première valeur de maximum de bande de valence Ev₁ avec un écart (appelé aussi décalage) d'énergie inférieur à 4.K_{b}T avec K_{b} la constante de Boltzmann et T la température de fonctionnement du détecteur. Le décalage de niveau des bandes de valence induit la création d'un champ électrique local E au niveau de chaque interface entre une structure planaire d'absorption du premier matériau m1 et une structure planaire d'absorption du deuxième matériau m2. Le champ électrique d'interface E au niveau de chaque interface a une direction parallèle à la direction Z de l'axe Δ du pixel. Cela permet de canaliser le mouvement des porteurs de charges photogénérés selon l'axe du pixel et ainsi réduire la diffusion des porteurs de charges selon le plan normal (X,Y) vers les pixels adjacents. Il est alors obtenu une réduction du phénomène de diaphonie entre les pixels à des valeurs de pas de pixels réduits.

Le premier matériau m1 et le deuxième matériau m2 sont des matériaux semi-conducteurs préférentiellement de type III-V.

La première et la deuxième valeur de gap d'énergie Eg₁ et Eg₂ sont proches l'une de l'autre avec une différence absolue inférieure à 20meV. Cela permet d'obtenir une hétérostructure d'absorption SPA apte à convertir les rayonnements à la longueur d'onde de fonctionnement. Avantageusement, la première et la deuxième valeur de gap d'énergie Eg₁ et Eg₂ sont égaux.

Avantageusement, la deuxième valeur de minimum de bande de conduction Ec₂ est distincte de la première valeur de minimum de bande de conduction Ec₁ avec un écart (appelé aussi décalage) d'énergie inférieur à 4.K_{b}T avec K_{b} la constante de Boltzmann et T la température de fonctionnement du détecteur.

La limitation des décalages entre les bandes d'énergie de valence (et de conduction) à 4K_{b}T permet de garder une configuration de bandes quasiment planaire du potentiel d'énergie dans la zone d'absorption. Ainsi, on évite la création de zone de charge d'espace avec désertion de porteurs de charge propice à la création d'un fort courant de génération - recombinaison dans l'hétérostructure d'absorption SPA selon l'invention. Il en résulte une réduction du phénomène de diaphonie sans augmenter le courant d'obscurité.

Dans l'exemple illustré, le nombre de répétition N est égal à 4 à titre indicatif non limitatif. L'effet technique relatif à l'invention est obtenu à partir de N=1, avec une première structure planaire d'absorption C₁₁ et une deuxième structure planaire d'absorption C₁₂. L'hétérostructure d'absorption SPA comprend au moins une première structure planaire d'absorption C₁₁ et une deuxième structure planaire d'absorption C₁₂ avec les caractéristiques de diagramme de bandes précitées. La première structure planaire d'absorption C₁₁ et la deuxième structure planaire d'absorption C₁₂ sont adjacentes. L'interface formée entre les deux structures planaires présente une différence de potentiel qui induit un champ électrique E ayant une direction parallèle à celle de l'axe Δ du pixel Pxl.

Une première structure planaire d'absorption Cᵢ₁ réalisée en le premier matériau m1 et de rang i présente une épaisseur eᵢ₁ selon la direction Z. Une deuxième structure planaire d'absorption Cᵢ₂ réalisée en le deuxième matériau m2 et de rang i présente une épaisseur eᵢ₂ selon la direction Z. L'épaisseur eᵢ₁ (et eᵢ₂) de chacune des structures planaires d'absorption Cᵢ₁ (et Cᵢ₂) est supérieure ou égale à 20nm. En effet, l'empilement alterné formant l'hétérostructure d'absorption SPA n'est pas un super-réseau ni un multi-puits quantique. On rappelle la définition d'un super-réseau et d'un puits quantique : En physique des semi-conducteurs, un super réseau est un empilement périodique de couches de faibles épaisseurs de quelques nanomètres. Si ces couches sont suffisamment fines (généralement inférieure à 10nm) un couplage quantique est possible. Les porteurs (trous et électrons) ont alors accès à un continuum énergétique selon des « mini-bandes ». Dans le cas d'un puits quantique, la couche avec le matériau qui a le minimum de la bande de conduction la plus basse en énergie et/ou le maximum de la bande de valence la plus haute en énergie possède une épaisseur inférieure à 20 nm, le ou les autres couches ayant une épaisseur supérieure à 20nm. Dans ce cas, les porteurs de charge accèdent à des niveaux énergétiques discrets selon l'axe de la période. Les épaisseurs eᵢ₁ et eᵢ₂ sont choisies afin d'éviter le couplage quantique entre les couches superposées et ainsi rester dans une structure de bandes d'énergie

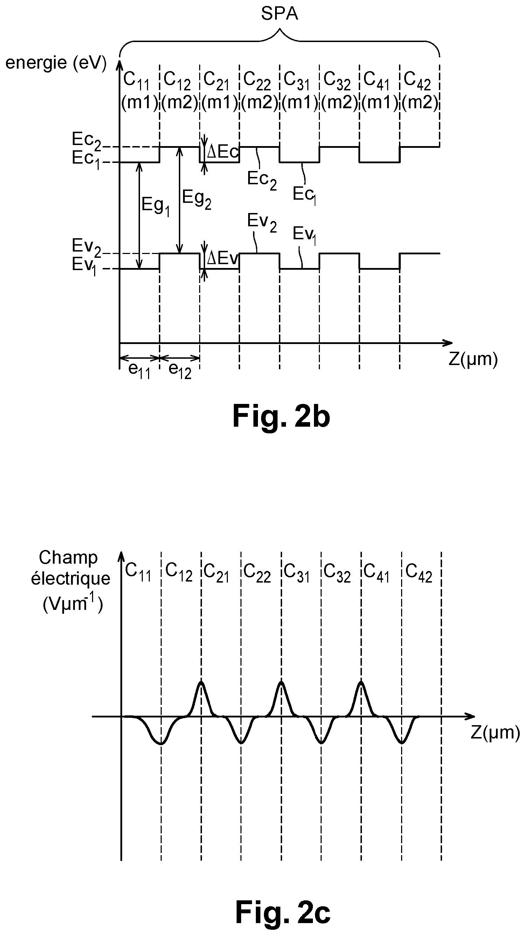

La figure 2b illustre la structure des bandes de l'hétérostructure d'absorption SPA dans la direction de l'axe du pixel Pxl de la figure 2a. On observe une structure de bandes alternée avec des variations de niveaux de valence ΔEv et des variations des niveaux de conduction ΔEc correspondant aux interfaces entre les couches adjacentes de différents matériaux. À titre d'exemple, lorsque les porteurs de charge positif sont collectés pour la détection, les variations de niveaux de valence ΔEv vues par les trous correspondent à des champs électriques d'interface selon l'axe du pixel. On obtient ainsi une canalisation des charges selon l'axe Δ. Cela permet de réduire le phénomène de diaphonie.

Le sens de migration des porteurs de charges photogénérés est dirigé de l'électrode inférieure EL_INF vers l'électrode supérieure EL_SUP à travers l'hétérostructure d'absorption SPA. D'une part, lors du passage d'une structure planaire en ledit premier matériau m1 (C₁₁, C₂₁, C₃₁...) vers une structure planaire en ledit deuxième matériau m2 (C₁₂, C₂₂, C₃₂...), le vecteur champ électrique d'interface **E** est dirigé selon un sens contraire au sens de migration. Dans ce cas, on considère que le champ électrique d'interface **E** est négatif. D'autre part, lors du passage d'une structure planaire en ledit deuxième matériau m2 vers une structure planaire en ledit premier matériau m1, le champ électrique d'interface **E** est dirigé selon le sens de migration. On considère dans ce cas que le champ électrique d'interface **E** est positif. La figure 2c illustre la distribution du champ électrique dans l'hétérostructure d'absorption SPA dans la direction de l'axe du pixel. L'alternance entre des champs électriques d'interface **E** négatifs et positifs est illustrée par ce diagramme. Les champs électriques d'interface **E** négatifs freinent le mouvement des porteurs de charge vers l'électrode supérieure EL_SUP et les champs électriques d'interface **E** positifs accélèrent le mouvement des porteurs de charge vers l'électrode supérieure EL_SUP. Cependant, malgré l'effet d'opposition desdits champs électriques d'interface **E** négatifs, les charges photogénérées se propagent toujours vers l'électrode supérieure EL_SUP sous l'effet global de la structure de bande.

Dans le cas où l'hétérostructure d'absorption SPA est constituée de deux structures planaires C₁₁ et C₁₂ tel que la première structure planaire C₁₁ déposée sur l'électrode inférieure EL_INF et la seconde structure planaire C₁₂ est déposée sur ladite première structure planaire C₁₁. La première structure planaire C₁₁ présente une première valeur de maximum de bande de valence Ev₁ supérieure à la valeur de maximum de bande de valence Ev₂ de la seconde structure planaire C₁₂ avec un écart (appelé aussi décalage) d'énergie inférieur à 4.K_{b}T avec K_{b} la constante de Boltzmann et T la température de fonctionnement du détecteur. Cela permet de créer un champ électrique d'interface **E** positif.

À titre d'exemple non limitatif du premier mode de réalisation de l'invention, le substrat SUB est en GaSb ; le premier matériau m1 est l'alliage InAs_{1-y1}Sb_{y1} avec y1 la fraction molaire du Sb dans l'alliage InAs_{1-y1}Sb_{y1} tel que 0,05≤y1≤0,15 ; le deuxième matériau m2 est l'alliage Gaₓ₂In₁₋ₓ₂As_{1-y2}Sb_{y2} avec x2 la fraction molaire du Ga dans l'alliage Gaₓ₂In₁₋ₓ₂As_{1-y2}Sb_{y2} tel que 0≤x2≤0,5 et y2 la fraction molaire de Sb dans l'alliage Gaₓ₂In₁₋ₓ₂As_{1-y2}Sb_{y2} tel que y2=0,914.x2+z avec 0,05≤ z ≤0,15. L'hétérostructure d'absorption SPA est réalisée par une croissance épitaxiale sur le substrat SUB.

À titre d'exemple non limitatif du premier mode de réalisation de l'invention, le substrat SUB est en InAs ; le premier matériau m1 est l'alliage InAs_{1-y3}Sb_{y3} avec y3 la fraction molaire du Sb dans l'alliage InAs_{1-y3}Sb_{y3} tel que 0≤y3≤0,07 ; le deuxième matériau m2 est l'alliage Gaₓ₄In₁₋ₓ₄As_{1-y4}Sb_{y4} avec x4 la fraction molaire du Ga dans l'alliage Gaₓ₄In₁₋ₓ₄As_{1-y4}Sb_{y4} tel que 0≤x4≤0,5 et y4 la fraction molaire de Sb dans l'alliage Gaₓ₄In₁₋ₓ₄As_{1-y4}Sb_{y4} tel que y1=0,914.x1+z avec 0≤ z ≤0,07. L'hétérostructure d'absorption SPA est réalisée par une croissance épitaxiale sur le substrat SUB.

À titre d'exemple non limitatif du premier mode de réalisation de l'invention, le substrat SUB est en InP ; le premier matériau m1 est l'alliage Ga_{1-y5}In_{y5}As avec y5 la fraction molaire du In dans l'alliage Ga_{1-y5}In_{y5}As tel que 0,46≤y5≤0,6 ; le deuxième matériau m2 est l'alliage Inₓ₆Ga₁₋ₓ₆As _{1-y6}P_{y6} avec x6 la fraction molaire du Ga dans l'alliage Inₓ₆Ga₁₋ₓ₆As _{1-y6}P _{y6} tel que 0,55≤x6≤0,85 et y6 la fraction molaire de P dans l'alliage Inₓ₆Ga₁₋ₓ₆As_{1-y6}P_{y6} tel que y6=2.x5-z avec 1,13≤ z ≤1,37. L'hétérostructure d'absorption SPA est réalisée par une croissance épitaxiale sur le substrat SUB.

À titre d'exemple non limitatif du premier mode de réalisation de l'invention, le substrat SUB est en InP ; le premier matériau m1 est l'alliage Gaₓ₇In₁₋ₓ₇As_{1-y7}Sb_{y7} avec x7 la fraction molaire du Ga dans l'alliage Gaₓ₇In₁₋ₓ₇As_{1-y7}Sb_{y7} tel que 0≤x7≤0,3 et avec y7 la fraction molaire du Sb dans l'alliage Gaₓ₇In₁₋ₓ₇As_{1-y7}Sb_{y7} tel que y7=-0,9.x7+z avec 0,46≤ z ≤ 0,5 ; le deuxième matériau m2 est l'alliage Gaₓ₈In₁₋ₓ₈As_{1-y8}Sb_{y8} avec x8 la fraction molaire du Ga dans l'alliage Gaₓ₈In₁₋ₓ₈As_{1-y8}Sb_{y8} tel que 0≤x8≤0,3 et avec y8 la fraction molaire du Sb dans l'alliage Gaₓ₈In₁₋ₓ₈As_{1-y8}Sb_{y8} tel que y8=-0,9.x8+z avec 0,46≤ z ≤ 0,5. La fraction molaire x7 du Ga dans l'alliage Gaₓ₇In₁₋ₓ₇As_{1-y7}Sb_{y7} du premier matériau m1 est différente de la fraction molaire x8 du Ga dans l'alliage Gaₓ₈In₁₋ₓ₈As_{1-y8}Sb_{y8} du deuxième matériau m2. La fraction molaire y7 du Sb dans l'alliage Gaₓ₇In₁₋ₓ₇As_{1-y7}Sb_{y7} du premier matériau m1 est différente de la fraction molaire y8 du Sb dans l'alliage Gaₓ₈In₁₋ₓ₈As_{1-y8}Sb_{y8} du deuxième matériau m2. L'hétérostructure d'absorption SPA est réalisée par une croissance épitaxiale sur le substrat SUB.

À titre d'exemple non limitatif du premier mode de réalisation de l'invention, le substrat SUB est en GaAs ; le premier matériau m1 est l'alliage In₁₋ₓ₉Gaₓ₉As _{1-y9}P_{y9} avec x9 la fraction molaire du Ga dans l'alliage In₁₋ₓ₉Gaₓ₉As_{1-y9}P_{y9} tel que 0≤x9≤0,3 et y9 la fraction molaire de P dans l'alliage In₁₋ₓ₉Gaₓ₉As _{1-y9}P_{y9} tel que y9=0,2.x9+z avec 0≤ z ≤0,05; le deuxième matériau m2 est l'alliage Ga₁₋ₓ₁₀Inₓ₁₀As avec x10 la fraction molaire du In dans l'alliage Ga₁₋ₓ₁₀Inₓ₁₀As tel que 0≤x10≤0,03. L'hétérostructure d'absorption SPA est réalisée par une croissance épitaxiale sur le substrat SUB.

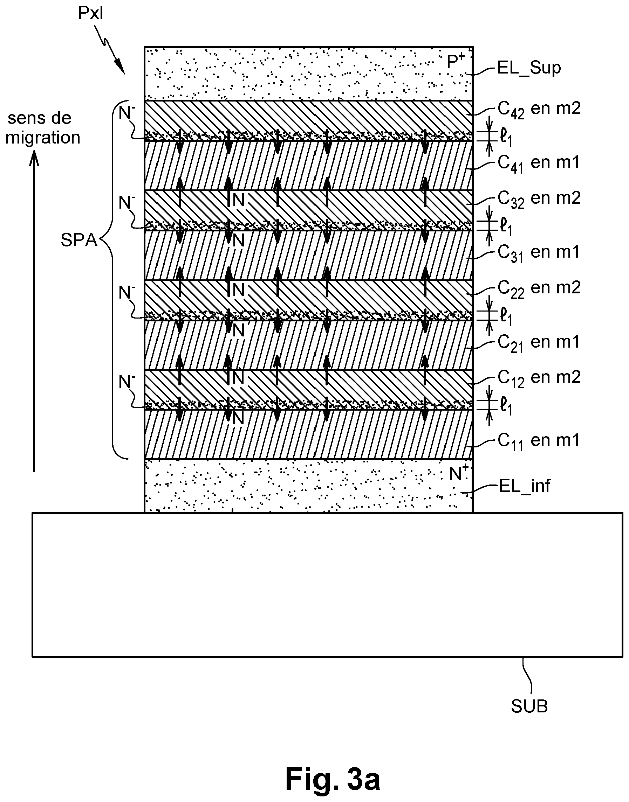

La figure 3a illustre une vue en coupe d'un pixel Pxl détecteur infrarouge comprenant une hétérostructure d'absorption SPA selon un deuxième mode de réalisation de l'invention. L'hétérostructure d'absorption SPA reprend les caractéristiques structurelles détaillées dans le premier mode de réalisation. La différence entre le premier mode de réalisation et le deuxième mode de réalisation consiste en la distribution du profil de dopage des structures planaires d'absorption Cᵢ₁ et Cᵢ₂ avec i=1 à N.

On considère un exemple où les porteurs de charge minoritaires sont les trous. Ainsi l'ensemble des couches empilées de l'hétérostructure d'absorption SPA est dopé N, selon une première concentration d'impuretés prédéterminée. Il a été établi que lors du passage des trous d'une structure planaire en le premier matériau m1 vers une structure planaire adjacente en le second matériau m2 selon le sens de migration, les trous voient un champ électrique d'interface **E** négatif. Dans ce mode de réalisation, au niveau de chaque interface présentant un champ électrique **E** négatif, une asymétrie de dopage est intégrée de part et d'autre de la dite interface. Plus particulièrement, la seconde structure planaire d'absorption en le second matériau m2 présente une zone de dopage d'interface N⁻ qui s'étend à partir de ladite interface vers le volume de ladite seconde structure planaire d'absorption en le second matériau m1. La zone de dopage d'interface N⁻ présente une seconde concentration d'impuretés inférieure à la première concentration d'impuretés prédéterminée. À titre d'exemple, chaque zone de dopage d'interface N⁻ est dopée avec une concentration de 2.10¹⁴cm⁻³ et le reste du volume de l'hétérostructure d'absorption SPA est dopé N avec une concentration de 1.10¹⁵cm⁻³. La zone de dopage d'interface N⁻ présente une profondeur de pénétration I1 dans le volume de la seconde structure planaire d'absorption supérieure à 10nm.

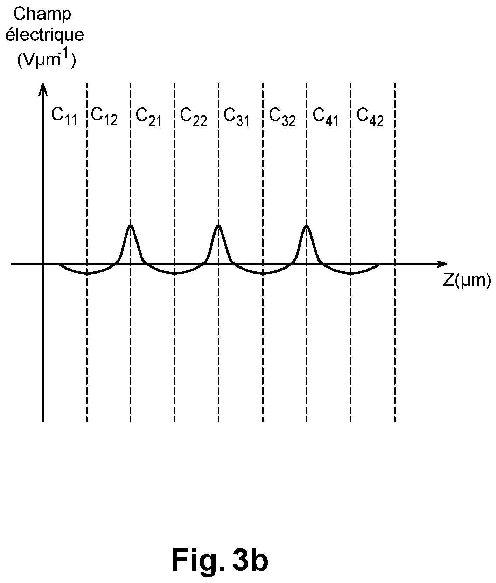

On réalise ainsi une asymétrie de dopage au niveau des interfaces ayant des champs électriques d'interface qui freinent le mouvement des porteurs de charges vers l'électrode supérieure de collection EL_SUP. L'asymétrie de dopage au niveau des interfaces permet de diminuer l'amplitude des champs électriques d'interface négatifs **E** et ainsi améliorer la mobilité des charges photogénérées selon l'axe du pixel Pxl. La figure 3b illustre la distribution du champ électrique dans l'hétérostructure d'absorption SPA dans la direction de l'axe du pixel Pxl avec l'asymétrie de dopage décrite précédemment.

Alternativement, le profil de dopage de type N de l'hétérostructure d'absorption SPA présente un gradient décroissant en partant de l'électrode inférieure EL_INF vers l'électrode supérieure EL_SUP. Cela permet d'avoir des champs électriques d'interface **E** plus intenses au niveau de la base du pixel Pxl par rapport au sommet à côté de l'électrode supérieure EL_SUP. Ainsi, l'effet de canalisation selon l'invention est accentué au niveau de la base du pixel Pxl là où le risque de diaphonie est plus important.

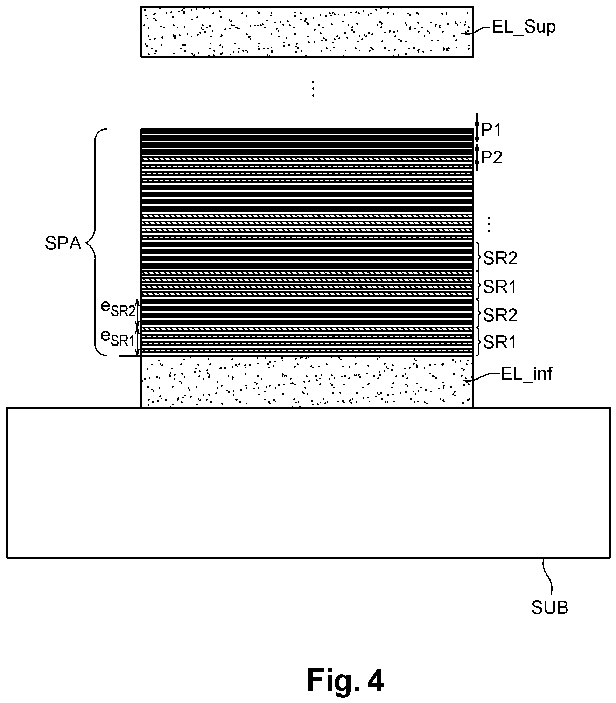

La figure 4 illustre une vue en coupe d'un pixel détecteur infrarouge Pxl comprenant une hétérostructure d'absorption SPA selon un troisième mode de réalisation de l'invention. L'hétérostructure d'absorption SPA comprend un premier groupe de N structures planaires d'absorption. Chaque structure du premier groupe est réalisée par un premier super réseau SR₁ avec N un entier naturel non nul. L'hétérostructure d'absorption SPA comprend en outre un second groupe de N structures planaires d'absorption. Chaque structure du second groupe est réalisée par un second super réseau SR₂ avec N un entier naturel non nul. Les super-réseaux SR₁ et SR₂ sont empilés de manière alternée pour obtenir une hétérostructure formée par différents super-réseaux adjacents. On rappelle que l'invention divulgue un empilement alterné d'au moins deux super-réseaux différents. Il ne s'agit pas d'un seul super-réseau unique. Le premier super réseau SR₁ est caractérisé par une première valeur de maximum de bande de valence Ev₁, une première valeur de minimum de bande de conduction Ec₁, et une première valeur de gap d'énergie E_{g1}. Le deuxième super réseau SR₂ est caractérisé par une deuxième valeur de maximum de bande de valence Ev₂, une deuxième valeur de minimum de bande de conduction Ec₂ et une deuxième valeur de gap d'énergie Eg₂. La deuxième valeur de maximum de bande de valence Ev₂ est distincte de la première valeur de maximum de bande de valence Ev₁ avec un écart (appelé aussi décalage) d'énergie inférieur à 4.KbT avec K_{b} la constante de Boltzmann et T la température de fonctionnement du détecteur. Le décalage de niveau des bandes de valence induit la création d'un champ électrique local **E** au niveau de chaque interface entre une structure planaire d'absorption réalisée par le premier super réseau SR₁ et une structure planaire d'absorption réalisée par le deuxième super réseau SR₂. On obtient ainsi le même diagramme de bandes d'énergie alterné décrit dans le premier mode de réalisation permettant de canaliser les porteurs de charges selon l'axe Δ du pixel et ainsi réduire le phénomène de diaphonie entre pixels adjacents.

Le premier super-réseau SR₁ et deuxième super-réseau SR₂ sont réalisés avec des matériaux semi-conducteurs préférentiellement de type III-V. Dans ce mode de réalisation, la zone d'absorption SPA est un empilement alternatif d'au moins deux super-réseaux différents ce qui ne correspond pas à un super-réseau en tant que tel.

D'une manière générale, les choix de conception d'un super-réseau selon l'invention couvrent le choix des matériaux utilisés (ingénierie des matériaux), l'épaisseur des couches qui composent super-réseau, la période du super-réseau (ici p₁ et p₂) et les fractions molaires dans le cas d'utilisation d'alliages. Selon un aspect particulier de l'invention, le deuxième super-réseau SR₂ est composé d'un empilement de couches en des matériaux différents de ceux qui forment le premier super-réseau SR₁. Alternativement, le deuxième super-réseau SR₂ est composé d'un empilement de couches des mêmes matériaux que ceux qui forment le premier super-réseau SR₁ mais avec des épaisseurs de couches différentes. Alternativement, le deuxième super-réseau SR₂ est composé d'un empilement de couches des mêmes matériaux que ceux qui forment le premier super-réseau SR₁ mais avec des périodes différentes p₁≠p₂. Alternativement, le deuxième super-réseau SR₂ est composé d'un empilement de couches des mêmes alliages que ceux qui forment le premier super-réseau SR₁ mais avec des fractions molaires différentes, des couches d'épaisseurs différentes et des périodes différentes p₁≠p₂.

À titre d'exemple non limitatif du troisième mode de réalisation de l'invention, le substrat SUB est en GaSb. Le premier super-réseau SR₁ est InAs_{1-y11}Sb_{y11}/Gaₓ₁₂In₁₋ₓ₁₂As_{1-y12}Sb_{y12} avec 0.084≤y11≤0.4 pour l'alliage ternaire et la plage en composition pour l'alliage quaternaire est un quadrilatère tel que 0,1 ≤ x12 ≤0,5 et en x12=0,1 : 0≤ y12 ≤0,25 et en x12=0,5 : 0,2≤ y12 ≤0,4. Les épaisseurs du ternaire e_{InAsSb} et du quaternaire e_{GaInAsSb} sont comprises entre 0,9nm≤e_{InAsSb} ≤2nm et 0,9nm≤e_{GaInAsSb} ≤5nm. Le deuxième super-réseau SR₂ est InAs_{1-y'11}Sb_{y'11}/Ga_{x'12}In_{1-x'12}As_{1-y'12}Sb_{y'12} avec 0,084≤y'11≤0,4 pour l'alliage ternaire et la plage en composition pour l'alliage quaternaire est un quadrilatère tel que 0,1 ≤ x'12 ≤0,5 et en x'12=0,1 : 0≤ y'12 ≤0,25 et en x'12=0,5 : 0,2≤ y'12 ≤0,4. Les épaisseurs du ternaire e_{InAsSb} et du quaternaire e'_{GaInAsSb} sont comprises entre 0,9nm≤e'_{InAsSb} ≤2nm et 0,9nm≤e'_{GaInAsSb} ≤5nm. Le deuxième super réseau SR₂ présente une période p₂ différente de celle p₁ du premier réseau SR₁ et/ou des fractions molaires d'alliages différentes des fractions molaires des alliages constituant le premier super réseau SR₁. L'hétérostructure d'absorption SPA est réalisée par une croissance épitaxiale sur le substrat SUB.

À titre d'exemple non limitatif du troisième mode de réalisation de l'invention, le substrat SUB est en InAs. Le premier super-réseau SR₁ est InAs_{1-y13}Sb_{y13}/Gaₓ₁₄In₁₋ₓ₁₄As_{1-y14}Sb_{y14} avec 0≤y13≤0,4 pour l'alliage ternaire et la plage en composition pour l'alliage quaternaire est un quadrilatère tel que 0,1 ≤ x14 ≤0,5 et en x14=0,1 : 0≤ y14 ≤0,25 et en x14=0,5 : 0,1≤ y14 ≤0,4. Les épaisseurs du ternaire e_{InAsSb} et du quaternaire e_{GaInAsSb} sont comprises entre 0,9nm≤e_{InAsSb} ≤2nm et 0,9nm≤e_{GaInAsSb} ≤5nm. Le deuxième super-réseau SR₂ est InAs_{1-y'13}Sb_{y'13}/Ga_{x'14}In_{1-x'14}As_{1-y'14}Sb_{y'14} avec 0≤y'13≤0,4 pour l'alliage ternaire et la plage en composition pour l'alliage quaternaire est un quadrilatère tel que 0,1 ≤ x'14 ≤0,5 et en x'14=0,1 : 0≤ y'14 ≤0,25 et en x'14=0,5 : 0,1≤ y'14 ≤0,4. Les épaisseurs du ternaire e_{InAsSb} et du quaternaire e'_{GaInAsSb} sont comprises entre 0,9nm≤e'_{InAsSb} ≤2nm et 0,9nm≤e'_{GaInAsSb} ≤5nm. Le deuxième super réseau SR₂ présente une période p₂ différente de celle p₁ du premier réseau SR₁ et/ou des fractions molaires d'alliages différentes des fractions molaires des alliages constituant le premier super réseau SR₁. L'hétérostructure d'absorption SPA est réalisée par une croissance épitaxiale sur le substrat SUB.

À titre d'exemple non limitatif du troisième mode de réalisation de l'invention, le substrat SUB est en InP. Le premier super-réseau SR1 est Inₓ₁₅Ga₁₋ₓ₁₅As/Inₓ₁₆Ga₁₋ₓ₁₆As_{1-y16}P_{y16} avec 0,45≤x15≤0,8 pour l'alliage ternaire et la plage en composition pour l'alliage quaternaire est un quadrilatère tel que 0,4 ≤ x16 ≤0,8 et en x16=0,4 : 0≤ y16 ≤0,2 et en x16=0,8 : 0,55≤ y16 ≤1. Les épaisseurs du ternaire e_{InGaAs} et du quaternaire e_{InGaAsP} sont comprises entre 0,9nm≤e_{InGaAs} ≤5nm et 0,9nm≤e_{InGaAsP} ≤5nm. Le deuxième super-réseau SR₂ est In_{x'15}Ga_{1-x'15}As/In_{x'16}Ga_{1-x'16}As_{1-y'16}P_{y'16} avec 0,45≤x'15≤0,8 pour l'alliage ternaire et la plage en composition pour l'alliage quaternaire est un quadrilatère tel que 0,4 ≤ x'16 ≤0,8 et en x'16=0,4 : 0≤ y'16 ≤0,2 et en x'16=0,8 : 0,55≤ y'16 ≤1. Les épaisseurs du ternaire e'_{InGaAs} et du quaternaire e'_{InGaAsP} sont comprises entre 0,9nm≤e'_{InGaAs} ≤5nm et 0,9nm≤e'_{InGaAsP} ≤5nm. Le deuxième super réseau SR₂ présente une période p₂ différente de celle p₁ du premier réseau SR₁ et/ou des fractions molaires d'alliages différentes des fractions molaires des alliages constituant le premier super réseau SR₁. L'hétérostructure d'absorption SPA est réalisée par une croissance épitaxiale sur le substrat SUB.

À titre d'exemple non limitatif du troisième mode de réalisation de l'invention, le substrat SUB est en InP. Le premier super-réseau SR₁ est Inₓ₁₇Ga₁₋ₓ₁₇As_{1-y17}Sb_{y17} /Inₓ₁₈Ga₁₋ₓ₁₈As_{1-y18}Sb_{y18} et le second super-réseau SR₂ est réalisé par les mêmes matériaux mais avec une période différente et/ou des coefficients stoechiométriques différents.

À titre d'exemple non limitatif du troisième mode de réalisation de l'invention, le substrat SUB est en GaAs. Le premier super-réseau SR₁ est Inₓ₁₉Ga₁₋ₓ₁₉As/Inₓ₂₀Ga₁₋ₓ₂₀As_{1-y20}P_{y20} avec 0≤x19≤0,2 pour l'alliage ternaire et la plage en composition pour l'alliage quaternaire est un quadrilatère tel que 0 ≤ x20 ≤0,3 et en x20=0 : 0≤ y20 ≤0,4 et en x20=0,3 : 0,6≤ y20 ≤1. Les épaisseurs du ternaire e_{InGaAs} et du quaternaire e_{InGaAsP} sont comprises entre 0,9nm ≤e_{InGaAs} ≤5nm et 0,9nm≤e_{InGaAsP} ≤5nm. Le deuxième super-réseau SR₂ est In_{x'19}Ga_{1-x'19}As/In_{x'20}Ga_{1-x'20}As_{1-y'20}P_{y'20} avec 0≤x'19≤0,2 pour l'alliage ternaire et la plage en composition pour l'alliage quaternaire est un quadrilatère tel que 0 ≤ x'20 ≤0,3 et en x'20=0 : 0≤ y'20 ≤0,4 et en x'20=0,3 : 0,6≤ y'20 ≤1. Les épaisseurs du ternaire e'_{InGaAs} et du quaternaire e'_{InGaAsP} sont comprises entre 0,9nm ≤e'_{InGaAs} ≤5nm et 0,9nm≤e'_{InGaAsP} ≤5nm. Le deuxième super réseau SR₂ présente une période p₂ différente de celle p₁ du premier réseau SR₁ et/ou des fractions molaires d'alliages différentes des fractions molaires des alliages constituant le premier super réseau SR₁. L'hétérostructure d'absorption SPA est réalisée par une croissance épitaxiale sur le substrat SUB.

Alternativement, il est possible de réaliser une hétérostructure d'absorption SPA selon l'invention dans laquelle le diagramme d'énergie alternée est obtenu par l'empilement alterné de couches massives avec des super-réseaux. Il s'agit d'un mode hybride entre le premier mode de réalisation et le troisième mode de réalisation.

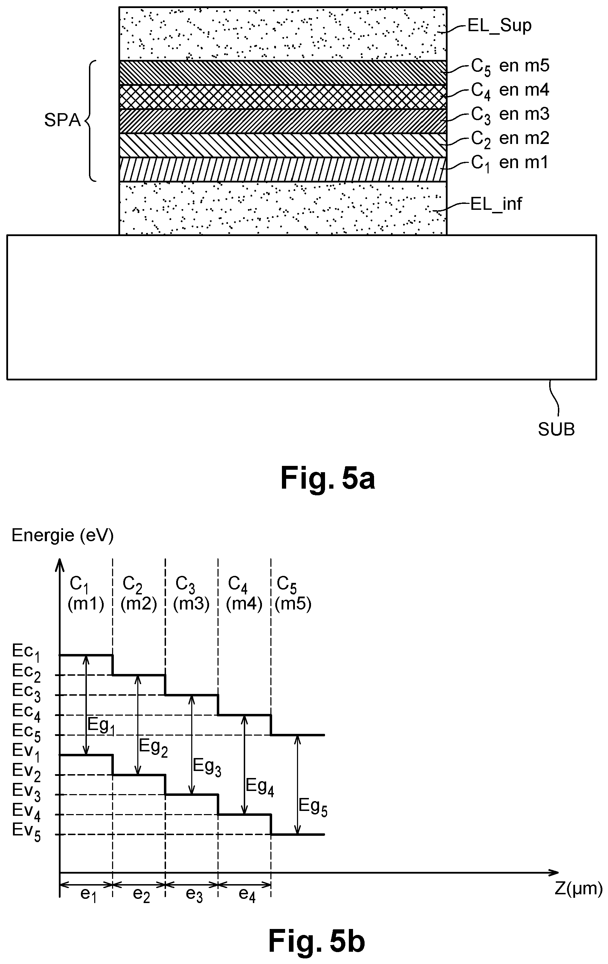

La figure 5a illustre une vue en coupe d'un pixel Pxl détecteur infrarouge comprenant une hétérostructure d'absorption SPA selon un quatrième mode de réalisation de l'invention. L'hétérostructure d'absorption SPA comprend un empilement d'une pluralité de structures planaires Cᵢ de rang i=1 à N avec N un entier naturel supérieur ou égal à 2. La première structure planaire C₁ est réalisée en une couche d'un premier matériau massif m1 ou en un premier super-réseau SR1. La deuxième structure planaire C₂ est réalisée en une couche d'un deuxième matériau massif m2 ou en un deuxième super-réseau SR2 et ainsi de suite. Dans le sens de migration des porteurs de charge minoritaires, chaque structure planaire d'absorption Cᵢ de rang i=1 à N-1 présente une valeur de maximum de bande de valence Evᵢ strictement supérieure à la valeur de maximum de bande de valence Evᵢ₊₁ de la structure planaire d'absorption Cᵢ₊₁ de rang i+1, avec un écart d'énergie inférieur à quatre fois le produit de la constante de Boltzmann par la température de fonctionnement. On obtient un diagramme d'énergie en escalier descendant en partant de l'électrode inférieure EL_INF vers l'électrode supérieure EL_SUP. L'écart absolu entre le gap d'énergie Egᵢ de la structure planaire d'absorption Cᵢ de rang i=1 à N-1 et la structure planaire d'absorption Cᵢ₊₁ est inférieur ou égal à 20 meV.

Avantageusement, chaque structure planaire d'absorption Cᵢ de rang i=1 à N-1 présente une valeur de minimum de bande de conduction Ecᵢ strictement supérieure à la valeur de minimum de bande de conduction Ec ᵢ₊₁ de la structure planaire d'absorption de rang i+1, avec un écart d'énergie inférieur à quatre fois le produit de la constante de Boltzmann par la température de fonctionnement.

On obtient ainsi une succession de plusieurs couches Cᵢ de rang i=1 à N en partant de EL_INF selon la première direction Z avec un diagramme de bandes d'énergie sous forme d'escalier descendant. La figure 5b illustre un schéma de la structure des bandes de l'hétérostructure d'absorption SPA selon le quatrième mode de réalisation de l'invention dans la direction de l'axe du pixel Pxl.

Les matériaux utilisés pour réaliser l'hétérostructure d'absorption sont des matériaux semi-conducteurs préférentiellement de type III-V.

Le choix des niveaux de valence et de conduction des structures planaires absorption Cᵢ permet d'obtenir un diagramme d'énergie sous forme d'escalier descendant. Chaque marche d'escalier d'énergie correspond à l'interface entre deux structures planaires d'absorption. Chaque écart d'énergie au niveau de l'interface induit un champ électrique d'interface **E** dirigé selon Z la direction de l'axe Δ du pixel Pxl.

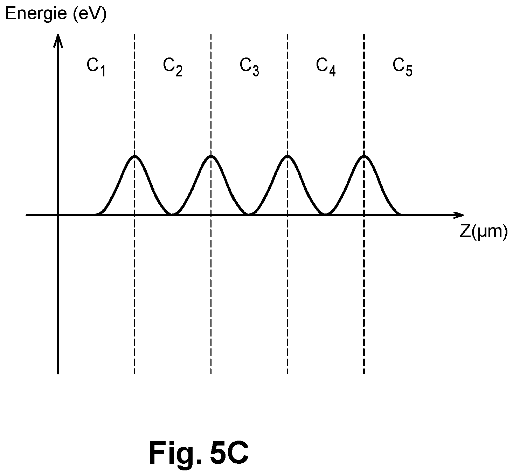

L'avantage de ce mode de réalisation est que la variation d'énergie est toujours dans le même sens permettant d'induire des champs électriques d'interface **E** positifs comme illustré sur la figure 5c. Le sens de **E** est ainsi tout le temps identique au sens de migration des porteurs de charge minoritaires.

À titre d'exemple non limitatif du quatrième mode de réalisation de l'invention, l'hétérostructure d'absorption SPA comprend la série suivante de super-réseaux SRᵢ empilés dans cet ordre InAs_{1-yi}Sb_{yi}/ GaₓIn₁₋ₓAs_{1-y'i}Sb_{y'i} avec i=[1,2,3,4] et 0.2 ≤ x ≤0.5 et tel que 0.7≤ y1,y1' ≤0.8 et 0.65≤ y2,y2' ≤0.75 et 0.6≤ y3,y3' ≤0.7 et 0.55≤ y4,y4' ≤0.65.

## Revendications

1. Dispositif de détection (D1) configuré pour détecter des rayonnements infrarouges à une température de fonctionnement prédéterminée, comprenant au moins un pixel (Pxl) réalisé par un empilement de couches sur un substrat (SUB) selon la première direction (Z) normale audit substrat (SUB), ledit pixel comprenant une hétérostructure d'absorption (SPA) ; ladite hétérostructure d'absorption (SPA) comprenant au moins:
- une première structure planaire d'absorption (C₁₁, SR₁) ayant une première valeur de maximum de bande de valence (Ev₁) ;
- et une deuxième structure planaire d'absorption (C₁₂, SR₂) adjacente à la première structure planaire d'absorption (C₁₁, SR₁) ;
ladite deuxième structure planaire d'absorption (C₁₂, SR₂) ayant une deuxième valeur de maximum de bande de valence (Ev₂) distincte de la première valeur de maximum de bande de valence (Ev₁) ;
l'épaisseur (e₁₁, e₁₂ , e_{SR1}, e_{SR2}) de chacune de la première et de la deuxième structure planaire d'absorption (C₁₁, SR₁, C₁₂, SR₂) étant supérieure ou égale à 20 nm ;
l'épaisseur (e₁₁, e₁₂ , e_{SR1}, e_{SR2}) de chacune de la première et de la deuxième structure planaire d'absorption étant choisie de manière à créer au moins un champ électrique d'interface (E) au niveau de l'interface entre la deuxième structure planaire d'absorption (C₁₂, SR₂) et la première structure planaire d'absorption (C₁₁, SR₁) ; ledit champ électrique d'interface (E) étant orienté selon ladite première direction (Z).

2. Dispositif de détection (D1) selon la revendication 1 dans lequel la différence entre la première valeur de maximum de bande de valence (Ev₁) et la deuxième valeur de maximum de bande de valence (Ev₂) est inférieure à quatre fois le produit de la constante de Boltzmann par la température de fonctionnement.

3. Dispositif de détection (D1) selon l'une quelconque des revendications précédentes dans lequel la première structure planaire d'absorption (C₁₁, SR₁) présente un premier gap d'énergie (Eg₁) et la deuxième structure planaire d'absorption (C₁₁, SR₁) présente un deuxième gap d'énergie (Eg₂) ; l'écart absolu entre le premier gap d'énergie (Eg₁) et le deuxième gap d'énergie (Eg₂) est inférieur ou égal à 20 meV .

4. Dispositif de détection (D1) selon l'une quelconque des revendications précédentes dans lequel la première structure planaire d'absorption (C₁₁, SR₁) présente une première valeur de minimum de bande de conduction (Ec₁) et la deuxième structure planaire d'absorption (C₁₂, SR₂) présente une deuxième valeur de minimum de bande de conduction (Ec₂) distincte de la première valeur de minimum de bande de conduction (Ec₁) avec un écart d'énergie inférieur à quatre fois le produit de la constante de Boltzmann par la température de fonctionnement.

5. Dispositif de détection (D1) selon l'une quelconque des revendications précédentes dans lequel l'hétérostructure d'absorption (SPA) comprend une alternance périodique de la première structure planaire d'absorption (C₁₁, SR₁) et de la deuxième structure planaire d'absorption (C₂₁, SR₂).

6. Dispositif de détection (D1) selon l'une quelconque des revendications 1 à 5 dans lequel l'hétérostructure d'absorption (SPA) est dopée par des dopants de type N ou P, la concentration desdits dopants étant asymétrique de part et d'autre d'au moins une interface entre une première structure planaire d'absorption (C₁₁, SR₁) et une deuxième structure planaire d'absorption (C₁₂, SR₂).

7. Dispositif de détection (D1) selon l'une quelconque des revendications 1 à 5 dans lequel ledit pixel (Pxl) comprend, en partant du substrat selon la première direction (Z) : une électrode inférieure (EL_INF), la zone d'absorption (SPA) et une électrode supérieure (EL_SUP) ; l'hétérostructure d'absorption (SPA) étant dopée par des dopants de type N ou P, la concentration desdits dopants présentant un gradient décroissant en partant de l'interface avec l'électrode inférieure vers l'interface avec l'électrode supérieure.

8. Dispositif de détection (D1) selon l'une quelconque des revendications précédentes dans lequel la zone d'absorption (SPA) comprend un empilement d'une succession de plusieurs structures planaires d'absorption (C₁, C₂, C₃, C₄, C₅) de rang i=1 à N croissant en partant du substrat (SUB) selon la première direction (Z), avec N un entier naturel strictement supérieur à 1, tel que :
- chaque structure planaire d'absorption (C₁, C₂, C₃, C₄) de rang i=1 à N-1 présente une valeur de maximum de bande de valence (Evᵢ) strictement supérieure à la valeur de maximum de bande de valence de la structure planaire d'absorption (Evᵢ₊₁) de rang i+1, de manière à créer au moins un champ électrique d'interface (E) dirigé selon la première direction (Z) au niveau de chaque interface ;
ladite succession de plusieurs structures planaires d'absorption (C₁, C₂, C₃, C₄, C₅) comprenant l'ensemble formé par la première structure planaire d'absorption (C₁₁, SR₁) et la deuxième structure planaire d'absorption (C₁₂, SR₂).

9. Dispositif de détection (D1) selon la revendication 8 dans lequel la différence entre d'une part la valeur de maximum de bande de valence (Evᵢ) d'une structure planaire d'absorption (C₁, C₂, C₃, C₄) de rang i=1 à N-1 et d'autre part la valeur de maximum de bande de valence (Evᵢ) d'une structure planaire d'absorption (C₂, C₃, C₄, C₅) adjacente de rang i+1 est inférieure à quatre fois le produit de la constante de Boltzmann par la température de fonctionnement .

10. Dispositif de détection (D1) selon l'une quelconque des revendications 8 ou 9 dans lequel l'écart absolu entre les gaps d'énergies associés à deux structures planaires d'absorption (C₁, C₂, C₃, C₄, C₅) adjacentes est inférieur ou égal à 20 meV.

11. Dispositif de détection (D1) selon l'une quelconque des revendications précédentes dans lequel chaque structure planaire d'absorption est réalisée par des matériaux semiconducteurs de type III-V.

12. Dispositif de détection (D1) selon l'une quelconque des revendications précédentes dans lequel le substrat est en GaSb ou en InAs ou en InP ou en GaAs.

13. Dispositif de détection (D1) selon l'une quelconque des revendications précédentes dans lequel :
- la première structure planaire d'absorption (C₁₁, SR₁) est réalisée par une première couche massive (C₁₁) en un premier matériau (m1) ou un premier super-réseau (SR₁) ;
- la deuxième structure planaire d'absorption (C₁₁, SR₁) est réalisée par une deuxième couche massive (C₁₂) en un deuxième matériau (m2) différent dudit premier matériau ou un deuxième super-réseau (SR₂).

14. Dispositif de détection (D1) selon la revendication 13 dans lequel le premier matériau (m1) est l'alliage InAs_{1-y}Sb_{y} ou l'alliage Ga₁₋ₓInₓAs ou l'alliage GaₓIn₁₋ₓAs_{1-y}Sb_{y} ou l'alliage GaₓIn₁₋ₓAs_{1-y}P_{y}.

15. Dispositif de détection (D1) selon l'une quelconque des revendications 13 ou 14 dans lequel le deuxième matériau (m2) est l'alliage GaₓIn₁₋ₓAs_{1-y}Sb_{y} ou l'alliage Ga₁₋ₓInₓAs ou l'alliage GaₓIn₁₋ₓAs_{1-y}P_{y}.

16. Dispositif de détection (D1) selon la revendication 15 dans lequel le premier super-réseau et/ou le deuxième super-réseau est constitué par une alternance selon une période spatiale prédéterminée (p1, p2) d'un couple de couches en InAs_{1-y}Sb_{y}/GaₓIn₁₋ₓAs_{1-y}Sb_{y};
ou en InₓGa₁₋ₓAs/InₓGa₁₋ₓAs_{1-y}P_{y ;}
ou en Inₓ₁Ga₁₋ₓ₁As_{1-y1}Sb_{y1} /Inₓ₂Ga₁₋ₓ₂As_{1-y2}Sb_{y2}

17. Dispositif de détection (D1) selon l'une quelconque des revendications précédentes comprenant une matrice de pixels (Pxl) ayant un pas de pixel inférieur ou égal à 15µm.

## Patentansprüche

1. Detektionsvorrichtung (D1), die konfiguriert ist, um Infrarotstrahlen bei einer vorbestimmten Betriebstemperatur zu detektieren, umfassend mindestens ein Pixel (PxI), das durch eine Stapelung von Schichten auf einem Substrat (SUB) in der ersten Richtung (Z) normal zum Substrat (SUB) realisiert wird, wobei das Pixel eine Absorptions-Heterostruktur (SPA) umfasst; wobei die Absorptions-Heterostruktur (SPA) mindestens umfasst:
- eine erste planare Absorptionsstruktur (C₁₁, SR₁), die einen ersten Valenzband-Höchstwert (Ev₁) aufweist;
- und eine zweite planare Absorptionsstruktur (C₁₂, SR₂) angrenzend an die erste planare Absorptionsstruktur (C₁₁, SR₁);
wobei die zweite planare Absorptionsstruktur (C₁₂, SR₂) einen zweiten Valenzband-Höchstwert (Ev₂) aufweist, der sich vom ersten Valenzband-Höchstwert (Ev₁) unterscheidet;
wobei die Dicke (e₁₁, e₁₂, e_{SR1}, e_{SR2}) einer jeden der ersten und der zweiten planaren Absorptionsstruktur (C₁₁, SR₁, C₁₂, SR₂) größer oder gleich 20 nm ist;
wobei die Dicke (e₁₁, e₁₂, e_{SR1}, e_{SR2}) einer jeden der ersten und der zweiten planaren Absorptionsstruktur ausgewählt wird, um mindestens ein elektrisches Schnittstellenfeld (E) im Bereich der Schnittstelle zwischen der zweiten planaren Absorptionsstruktur (C₁₂, SR₂) und der ersten planaren Absorptionsstruktur (C₁₁, SR₁) zu erstellen; wobei das elektrische Schnittstellenfeld (E) in der ersten Richtung (Z) ausgerichtet ist.

2. Detektionsvorrichtung (D1) nach Anspruch 1, wobei die Differenz zwischen dem ersten Valenzband-Höchstwert (Ev₁) und dem zweiten Valenzband-Höchstwert (Ev₂) kleiner als das Vierfache des Produkts der Boltzmann-Konstante mal der Betriebstemperatur ist.

3. Detektionsvorrichtung (D1) nach einem der vorstehenden Ansprüche, wobei die erste planare Absorptionsstruktur (C₁₁, SR₁) eine erste Bandlücke (Eg₁) aufweist und die zweite planare Absorptionsstruktur (C₁₁, SR₁) eine zweite Bandlücke (Eg₂) aufweist; wobei die absolute Abweichung zwischen der ersten Bandlücke (Eg₁) und der zweiten Bandlücke (Eg₂) kleiner oder gleich 20 meV ist.

4. Detektionsvorrichtung (D1) nach einem der vorstehenden Ansprüche, wobei die erste planare Absorptionsstruktur (C₁₁, SR₁) einen ersten Leitungsband-Mindestwert (Ec₁) aufweist, und die zweite planare Absorptionsstruktur (C₁₂, SR₂) einen zweiten Leitungsband-Mindestwert (Ec₂) aufweist, der sich vom ersten Leitungsband-Mindestwert (Ec₁) unterscheidet, mit einer Energieabweichung kleiner als das Vierfache des Produkts der Boltzmann-Konstante mal der Betriebstemperatur.

5. Detektionsvorrichtung (D1) nach einem der vorstehenden Ansprüche, wobei die Absorptions-Heterostruktur (SPA) eine periodische Abwechslung der ersten planaren Absorptionsstruktur (C₁₁, SR₁) und der zweiten planaren Absorptionsstruktur (C₂₁, SR₂) umfasst.

6. Detektionsvorrichtung (D1) nach einem der Ansprüche 1 bis 5, wobei die Absorptions-Heterostruktur (SPA) mit Dotierstoffen vom N- oder P-Typ dotiert ist, wobei die Konzentration der Dotierstoffe beiderseits der mindestens einen Schnittstelle zwischen einer ersten planaren Absorptionsstruktur (C₁₁, SR₁) und einer zweiten planaren Absorptionsstruktur (C₁₂, SR₂) asymmetrisch ist.

7. Detektionsvorrichtung (D1) nach einem der Ansprüche 1 bis 5, wobei das Pixel (PxI) ausgehend vom Substrat in der ersten Richtung (Z) umfasst: eine untere Elektrode (EL_INF), den Absorptionsbereich (SPA) und eine obere Elektrode (EL_SUP); wobei die Absorptions-Heterostruktur (SPA) mit Dotierstoffen vom N- oder P-Typ dotiert ist, wobei die Konzentration der Dotierstoff ausgehend von der Schnittstelle mit der unteren Elektrode zur Schnittstelle mit der oberen Elektrode einen abnehmenden Gradienten aufweist.

8. Detektionsvorrichtung (D1) nach einem der vorstehenden Ansprüche, wobei der Absorptionsbereich (SPA) eine Stapelung einer Aufeinanderfolge mehrerer planarer Absorptionsstrukturen (C₁, C₂, C₃, C₄, C₅) von ansteigendem Rang i=1 bis N ausgehend vom Substrat (SUB) in der ersten Richtung (Z) umfasst, wobei N eine ganze natürliche Zahl streng größer als 1 ist, sodass:
- jede planare Absorptionsstruktur (C₁, C₂, C₃, C₄) von Rang i=1 bis N-1 einen Valenzband-Höchstwert (Evᵢ) streng größer als den Valenzband-Höchstwert der planaren Absorptionsstruktur (Evᵢ₊₁) von Rang i+1 aufweist, um mindestens ein elektrisches Schnittstellenfeld (E) zu erstellen, das im Bereich jeder Schnittstelle in die erste Richtung (Z) gerichtet ist;
wobei die Aufeinanderfolge mehrerer planarer Absorptionsstrukturen (C₁, C₂, C₃, C₄, C₅) die Einheit umfasst, die durch die erste planare Absorptionsstruktur (C₁₁, SR₁) und die zweite planare Absorptionsstruktur (C₁₂, SR₂) gebildet wird.

9. Detektionsvorrichtung (D1) nach Anspruch 8, wobei die Differenz zwischen einerseits dem Valenzband-Höchstwert (Evᵢ) einer planaren Absorptionsstruktur (C₁, C₂, C₃, C₄) von Rang i=1 bis N-1 und andererseits dem Valenzband-Höchstwert (Evᵢ) einer benachbarten planaren Absorptionsstruktur (C₂, C₃, C₄, C₅) von Rang i+1 kleiner als das Vierfache des Produkts der Boltzmann-Konstante mal der Betriebstemperatur ist.

10. Detektionsvorrichtung (D1) nach einem der Ansprüche 8 oder 9, wobei die absolute Abweichung zwischen den Bandlücken, die zwei benachbarten planaren Absorptionsstrukturen (C₁, C₂, C₃, C₄, C₅) zugeordnet sind, kleiner oder gleich 20 meV ist.

11. Detektionsvorrichtung (D1) nach einem der vorstehenden Ansprüche, wobei jede planare Absorptionsstruktur mit Halbleitermaterialien vom Typ III-V realisiert ist.

12. Detektionsvorrichtung (D1) nach einem der vorstehenden Ansprüche, wobei das Substrat aus GaSb oder aus InAs oder aus InP oder aus GaAs ist.

13. Detektionsvorrichtung (D1) nach einem der vorstehenden Ansprüche, wobei:
- die erste planare Absorptionsstruktur (C₁₁, SR₁) durch eine erste massive Schicht (C₁₁) aus einem ersten Material (m1) oder ein erstes Supergitter (SR₁) realisiert ist;
- die zweite planare Absorptionsstruktur (C₁₁, SR₁) durch eine zweite massive Schicht (C₁₂) aus einem zweiten Material (m2), das sich vom ersten Material unterscheidet, oder ein zweites Supergitter (SR₂) realisiert ist.

14. Detektionsvorrichtung (D1) nach Anspruch 13, wobei das erste Material (m1) die lnAs_{1-y}Sb_{y} Legierung oder die Ga₁₋ₓlnₓAs Legierung oder die Gaₓln₁₋ₓAs_{1-y}Sb_{y} Legierung oder die Gaₓln₁₋ₓAs_{1-y}P_{y} Legierung ist.

15. Detektionsvorrichtung (D1) nach einem der Ansprüche 13 oder 14, wobei das zweite Material (m2) die Gaₓln₁₋ₓAs_{1-y}Sb_{y} Legierung oder die Ga₁₋ₓlnₓAs Legierung oder die GaₓIn₁₋ₓAs_{1-y}P_{y} Legierung ist.

16. Detektionsvorrichtung (D1) nach Anspruch 15, wobei das erste Supergitter und/oder das zweite Supergitter aus einer Abwechslung entsprechend einer vorbestimmten räumlichen Periode (p1, p2) eines Paares von Schichten aus InAs_{1-y}Sb_{y}/GaₓIn₁₋ₓAs_{1-y}Sb_{y} bestehen;
oder aus lnₓGa₁₋ₓAs/lnₓGa₁₋ₓAs_{1-y}P_{y};
oder aus lnₓ₁Ga₁₋ₓ₁As_{1-y1}Sb_{y1} /lnₓ₂Ga₁₋ₓ₂As_{1-y2}Sb_{y2}

17. Detektionsvorrichtung (D1) nach einem der vorstehenden Ansprüche, umfassend eine Matrix aus Pixeln (PxI), die einen Pixelabstand kleiner oder gleich 15 µm aufweist.

## Claims

1. Detection device (D1) configured to detect infrared radiation at a predetermined opening temperature, comprising at least one pixel (Pxl) produced by a stack of layers on a substrate (SUB) in the first direction (Z) normal to said substrate (SUB), said pixel comprising an absorption heterostructure (SPA); said absorption heterostructure (SPA) comprising at least:
- a first planar absorption structure (C₁₁, SR₁) having a first maximum valence band value (Ev₁);
- and a second planar absorption structure (C₁₂, SR₂) adjacent to the first planar absorption structure (C₁₁, SR₁);
said second planar absorption structure (C₁₂, SR₂) having a second maximum valence band value (Ev₂) distinct from the first maximum valence band value (Ev₁);
the thickness (e₁₁, e₁₂, e_{SR1}, e_{SR2}) of each of the first and second planar absorption structures (C₁₁, SR₁, C₁₂, SR₂) being greater than or equal to 20nm;
the thickness (e₁₁, e₁₂, e_{SR1}, e_{SR2}) of each of the first and second planar absorption structures being chosen, so as to create at least one interface electric field (E) at the interface between the second planar absorption structure (C₁₂, SR₂) and the first planar absorption structure (C₁₁, SR₁); said interface electric field (E) being oriented in said first direction (Z).

2. Detection device (D1) according to claim 1, wherein the difference between the first maximum valence band value (Ev₁) and the second maximum valence band value (Ev₂) is less than four times the product of the Boltzmann constant by the operating temperature.

3. Detection device (D1) according to any one of the preceding claims, wherein the first planar absorption structure (C₁₁, SR₁) has a first energy gap (Eg₁) and the second planar absorption structure (C₁₁, SR₁) has a second energy gap (Eg₂); the absolute difference between the first energy gap (Eg₁) and the second energy gap (Eg₂) is less than or equal to 20meV.

4. Detection device (D1) according to any one of the preceding claims, wherein the first planar absorption structure (C₁₁, SR₁) has a first minimum conduction band value (Ec₁) and the second planar absorption structure (C₁₂, SR₂) has a second minimum conduction band value (Ec₂) distinct from the first minimum conduction band value (Ec₁) with an energy difference less than four times the product of the Boltzmann constant by the operating temperature.

5. Detection device (D1) according to any one of the preceding claims, wherein the absorption heterostructure (SPA) comprises a periodic alternance of the first planar absorption structure (C₁₁, SR₁) and of the second planar absorption structure (C₂₁, SR₂).

6. Detection device (D1) according to any one of claims 1 to 5, wherein the absorption heterostructure (SPA) is doped by N- or P-type dopants, the concentration of said dopants being asymmetric on either side of at least one interface between a first planar absorption structure (C₁₁, SR₁) and a second planar absorption structure (C₁₂, SR₂).

7. Detection device (D1) according to any one of claims 1 to 5, wherein said pixel (Pxl) comprises, starting from the substrate in the first direction (Z): a lower electrode (EL_INF), the absorption zone (SPA) and an upper electrode (EL_SUP); the absorption heterostructure (SPA) being doped by Nor P-type dopants, the concentration of said dopants having an increasing gradient starting from the interface with the lower electrode to the interface with the upper electrode.

8. Detection device (D1) according to any one of the preceding claims, wherein the absorption zone (SPA) comprises a stack of a succession of several planar absorption structures (C₁, C₂, C₃, C₄, C₅) of row i=1 to N increasing, starting from the substrate (SUB) in the first direction (Z), with N a natural integer strictly greater than 1, such that:
- each planar absorption structure (C₁, C₂, C₃, C₄) of row i=1 to N-1 has a maximum valence band value (Evᵢ) strictly greater than the maximum valence band value of the planar absorption structure (Evᵢ₊₁) of row i+1, so as to create at least one interface electric field (E) directed in the first direction (Z) at each interface;
said succession of several planar absorption structures (C₁, C₂, C₃, C₄, C₅) comprising the assembly formed by the first planar absorption structure (C₁₁, SR₁) and the second planar absorption structure (C₁₂, SR₂).

9. Detection device (D1) according to claim 8, wherein the difference between, on the one hand, the maximum valence band value (Ev₁) of a planar absorption structure (C₁, C₂, C₃, C₄) of row i=1 to N-1 and on the other hand, the maximum valence band value (Evᵢ) of an adjacent planar absorption structure (C₂, C₃, C₄, C₅) of row i+1 is less than four times the product of the Boltzmann constant by the operating temperature.

10. Detection device (D1) according to any one of claims 8 or 9, wherein the absolute difference between the energy gaps associated with two adjacent planar absorption structures (C₁, C₂, C₃, C₄, C₅) is less than or equal to 20meV.

11. Detection device (D1) according to any one of the preceding claims, wherein each planar absorption structure is produced by III-V-type semiconductor materials.

12. Detection device (D1) according to any one of the preceding claims, wherein the substrate is made of GaSb or InAs or InP or GaAs.

13. Detection device (D1) according to any one of the preceding claims, wherein:
- the first planar absorption structure (C₁₁, SR₁) is produced by a first solid layer (C₁₁) made of a first material (m1) or a first super-network (SR₁);
- the second planar absorption structure (C₁₁, SR₁) is produced by a second solid layer (C₁₂) made of a second material (m2) different from said first material or a second super-network (SR₂).

14. Detection device (D1) according to claim 13, wherein the first material (m1) is the alloy InAs_{1-y}Sb_{y} or the alloy Ga₁₋ₓlnₓAs or the alloy Gaₓln₁₋ₓAs_{1-y}Sb_{y} or the alloy GaₓIn₁₋ₓAs_{1-y}P_{y}.

15. Detection device (D1) according to any one of claims 13 or 14, wherein the second material (m2) is the alloy Gaₓln₁₋ₓAs_{1-y}Sb_{y} or the alloy Ga₁₋ₓlnₓAs or the alloy GaₓIn₁₋ₓAs_{1-y}P_{y}.

16. Detection device (D1) according to claim 15, wherein the first super-network and/or the second super-network is constituted by an alternance according to a predetermined spatial period (p1, p2) of a pair of layers made of InAs_{1-y}Sb_{y}/GaₓIn₁₋ₓAs_{1-y}Sb_{y};
or InₓGa₁₋ₓAs/InₓGa₁₋ₓAs_{1-y}P_{y};
or Inₓ₁Ga₁₋ₓ₁As_{1-y1}Sb_{y1}/Inₓ₂Ga₁₋ₓ₂As_{1-y2}Sb_{y2}.

17. Detection device (D1) according to any one of the preceding claims, comprising a pixel (Pxl) matrix having a pixel pitch less than or equal to 15µm.
